Europäisches Patentamt

European Patent Office

Office européen des brevets

(11) Numéro de publication: **0 289 431 B1**

## FASCICULE DE BREVET EUROPEEN

(45) Date de publication de fascicule du brevet: **10.03.93**  (51) Int. Cl.⁵: **H01L 27/02**

(21) Numéro de dépôt: **88420095.7**

(22) Date de dépôt: **23.03.88**

(54) **Circuit intégré protégé contre des surtensions.**

(30) Priorité: **27.03.87 FR 8704270**

(43) Date de publication de la demande:
**02.11.88 Bulletin 88/44**

(45) Mention de la délivrance du brevet:
**10.03.93 Bulletin 93/10**

(84) Etats contractants désignés:
**DE FR GB IT NL SE**

(56) Documents cités:
**DE-A- 2 514 466**
**FR-A- 2 217 810**

(73) Titulaire: **SGS-THOMSON MICROELECTRO-
NICS S.A.**
**101 Boulevard Murat**
**F-75016 Paris(FR)**

(72) Inventeur: **Renous, Claude**
**40 Galerie des Balladins**
**F-38100 Grenoble(FR)**

(74) Mandataire: **de Beaumont, Michel et al**
**1bis, rue Champollion**
**F-38000 Grenoble (FR)**

Rank Xerox (UK) Business Services
(3.10/3.5x/3.0.1)

## Description

La présente invention concerne les circuits-intégrés, et plus particulièrement la protection de ces circuits contre des surtensions susceptibles soit d'affecter leur fonctionnement soit de les détruire.

L'invention sera décrite plus précisément à propos d'un circuit-intégré d'interface entre un central téléphonique et un poste téléphonique d'abonné, mais l'invention n'est pas limitée à ces circuits.

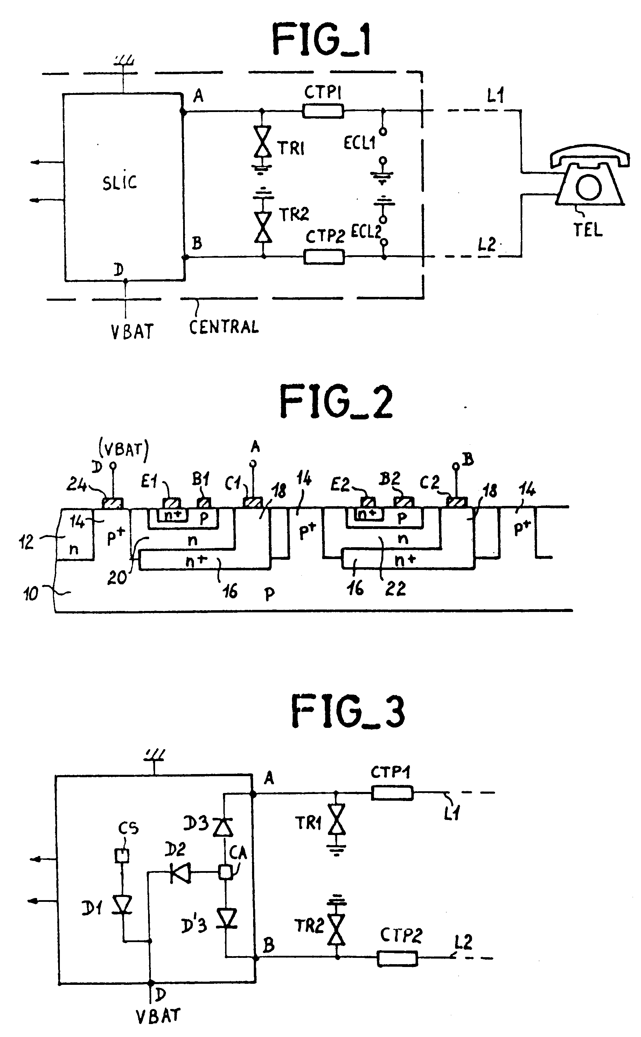

Un tel circuit d'interface, ou joncteur d'abonné, connu aussi sous la dénomination "SLIC" ( de l'anglais Subscriber Line Interface Circuit) est connecté entre le central téléphonique et deux conducteurs de ligne téléphonique L1 et L2 (voir figure 1); à l'extrémité opposée de la ligne est connecté un poste téléphonique d'abonné(TEL).

Les conducteurs de ligne s'étendent sur des distances importantes et sont soumis de ce fait à des perturbations pouvant engendrer des surtensions sur ces conducteurs.

Par exemple, les surtensions proviennent des orages, d'inductions électromagnétiques diverses, de contacts accidentels avec les lignes de transport d'énergie électrique, etc.

Dans tous ces cas, les niveaux d'énergie mis en jeu sont considérables et les circuits placés aux extrémités de la ligne doivent faire l'objet de mesures de protection importantes.

La première mesure consiste à disposer des éclateurs ECL1 et ECL2 entre chaque conducteur de ligne et la terre.

La seconde mesure consiste à disposer une résistance à coefficient de température positif CTP1, CTP2, en série dans chaque conducteur de ligne pour supprimer les surcharges de courant destructices: si une surcharge de courant se produit, ces résistances chauffent et leur résistance croît considérablement (elle passe par exemple de 30 ohms à plusieurs mégohms) de sorte que le courant est interrompu.

La troisième mesure consiste à disposer entre chaque conducteur de ligne et la terre des composants électroniques de protection du type diode zener, ou mieux encore du type thyristor sans gâchette. Ces composants, TR1, TR2, ont une haute impédance tant que la tension à leurs bornes ne dépasse pas un certain seuil Vz; puis ils deviennent conducteurs et écoulement le courant vers la terre lorsque le seuil Vz est dépassé; la tension à leurs bornes reste égale à Vz dans le cas d'une diode zener; elle chute à une très faible valeur dans le cas d'un thyristor sans gâchette. Les composants TR1, TR2, sont placés en général entre une borne de sortie A ou B du circuit-intégré constituant le joncteur d'abonné et la terre; les bornes A et B sont reliées aux conducteurs de ligne par l'intermédiaire des résistances à coefficient de température positif.

Le choix de la valeur du seuil Vz est critique dans l'application considérée, pour les raisons qu'on va exposer ci-après et qui sont liées à la fois au mode d'alimentation en énergie du joncteur d'abonné et à la réalisation technologique du circuit-intégré.

Il faut d'abord considérer qu'on veut éviter en tout état de cause que la borne A ou B reçoive un potentiel supérieur à un seuil absolu de tenue en tension du circuit-intégré: par exemple ce seuil est VMAX = 110 volts (seuil admissible entre la borne A ou B et la terre). Au dela de ce seuil il y a claquage des jonctions internes au circuit-intégré.

Par conséquent il faut que Vz soit inférieur à VMAX.

D'autre part, le joncteur d'abonné est alimenté par une tension continue VBAT négative par rapport à la masse, cette tension pouvant d'ailleurs se retrouver parfois, en fonctionnement normal du circuit, sur les bornes A et B.

La tension VBAT a une valeur nominale de 48 volts (en réalité il s'agit d'un valeur négative de -48 volts mais, jusqu'aux explications relatives à la figure 2, il est plus simple de parler en valeurs absolues).

Mais il est spécifié que la tension d'alimentation peut varier entre deux valeurs (en valeur absolue)

VBATmin = 34 volts
et VBATmax = 72 volts

sans altérer le fonctionnement du circuit.

Il est nécessaire par conséquent que la tension de déclenchement Vz des composants de protection soit au minimum égale à VBATmax, faute de quoi les composants de protection se déclencheraient même dans certain cas de fonctionnement normal du circuit, ce qui n'est pas admissible.

On doit donc choisir des composants TR1 et TR2 ayant une tension de déclenchement Vz comprise entre VBATmax et VMAX, soit, dans l'exemple considéré, entre 72 volts et 110 volts.

Il en résulte alors une possibilité de disfonctionnement pouvant aboutir à la direction du circuit-intégré, ceci pour une raison liée à la technologie de fabrication du circuit-intégré, ce que l'on va maintenant expliquer en référence à la figure 2; cette figure représente en coupe d'une manière simplifiée une partie de structure de circuit-intégré telle qu'on peut la rencontrer dans un joncteur d'abonné.

Compte-tenu des tensions relativement élevées que le circuit doit pouvoir supporter, il est réalisé en technologie bipolaire, sur un substrat de silicium 10 de type p recouvert d'une couche épitaxiale 12 de type n. La couche épitaxiale est divisée en caissons isolés les uns des autres par des diffusions profondes 14 de type p qui partent de la surface supérieure de la couche et qui rejoignent le substrat. Des couches enterrées 16 de type n+ peuvent être prévues au fond des caissons, entre la couche épitaxiale 12 et le substrat, et ces couches enterrées peuvent être reliées à la surface supérieure par des diffusions profondes 18 de type n+.

Des transistors individuels sont réalisés dans les caissons et sont isolés des transistors adjacents ou d'autres éléments de circuit par les diffusions d'isolement 14 de type p.

On a représenté à titre d'exemple un transistor de sortie du joncteur d'abonné dont le collecteur est constitué par un contact métallique C1 à la surface d'une diffusion 18 de type n+, et dont l'émetteur et la base sont deux autres contacts superficiels E1 et B1 sur des zones d'émetteur et de base appropriées d'un premier caisson 20. On a représenté un autre transistor constitué de la même manière (E2, B2, C2) dans un autre caisson 22.

Par exemple, le collecteur C1 est relié à la borne de sortie A du circuit-intégré (cf. figure 1), le collecteur C2 est relié à la borne B, et la tension d'alimentation VBAT est appliquée à une borne de sortie D. Classiquement, la borne D est reliée (à l'intérieur du circuit-intégré) à un contact métallique 24 formé sur une diffusion profonde 14 de type p qui rejoint le substrat, de sorte que le potentiel d'alimentation négatif VBAT est appliqué au substrat.

L'application du potentiel négatif au substrat est tout à fait classique pour des circuits-intégrés réalisés dans une couche épitaxiale de type n sur substrat de type p; en effet, en mettant le substrat p au potentiel le plus négatif, on est certain que les potentiels de toutes les autres parties du circuit-intégré, et notamment de toutes les régions de type n adjacentes au substrat ou aux diffusions d'isolement, seront supérieurs au potentiel du substrat et de ces diffusions. Il en résulte que les diffusions d'isolement sont bien polarisées négativement par rapport aux régions qu'elles doivent isoler, et c'est là une condition nécessaire pour qu'elles jouent bien leur rôle d'isolement.

Mais ces fonctions d'isolement risquent de n'être plus assurées en cas de surtensions négatives appliquées aux bornes A et B si ces surtensions excèdent en valeur absolue le potentiel VBAT du substrat.

En effet, dans ce cas les diffusions d'isolement deviennent polarisées en direct; elles tendent à faire conduire des transistors parasites entre caissons adjacents, drainant ainsi un pouvant entrainer la destruction du circuit.

Cette situation risque de se produire si on a choisi un potentiel de déclenchement Vz compris entre VBATmax et VMAX, comme on a dit plus haut qu'il était nécessaire de le faire. Par exemple si on choisit Vz égale ou légèrement supérieure à VBATmax et si une surtension inférieure à VBATmax (72 volts) se produit alors que la tension de la batterie a par exemple sa valeur nominale VBAT, le composant de protection TR1 ou TR2 ne se déclenchera pas, et pourtant le potentiel sur la borne A (entre VBAT et VBATmax) sera plus négatif que le potentiel du substrat (VBAT), provoquant ainsi le défaut mentionné au paragraphe précédent.

Il y a donc incompatibilité entre les diverses nécessités de protection et le fait que la tension d'alimentation peut varier dans de larges limites.

Pour remédier à cet inconvénient, la présente invention propose un circuit-intégré protégé contre les surtensions, ce circuit étant réalisé sur un substrat d'un premier type de conductivité recouvert d'une couche épitaxiale de type opposé, le circuit comportant au moins une borne d'alimentation extérieure, des conducteurs d'alimentation internes au circuit pour transmettre une tension d'alimentation aux divers composants du circuit, et au moins une borne de sortie. Selon l'invention, le circuit-intégré comporte une première diode reliée entre le substrat et la borne d'alimentation extérieure, ayant sa cathode reliée à cette borne si le substrat est de type p, une deuxième diode reliée entre les conducteurs d'alimentation interne et la borne d'alimentation extérieure, ayant sa cathode reliée à la borne d'alimentation extérieure si le substrat est de type p, et une troisième diode reliée entre les conducteurs d'alimentation interne et la borne de sortie, ayant sa cathode reliée à la borne de sortie si le substrat est de type p, cette troisième diode étant réalisée par une jonction entre deux régions de type de conductivité opposés qui sont toutes deux électriquement isolées du substrat et les première et deuxième diodes ayant pour anode des régions de type p isolées du substrat.

Par régions isolées du substrat, il faut entendre qu'une isolation par jonction polarisée en inverse est prévue, mais dans des technologies particulières, on pourrait envisager aussi une isolation diélectrique sans sortir du cadre de l'invention.

Il est particulièrement souhaitable que la première et la deuxième diode soient aussi réalisées à partir de jonctions entre régions isolées du substrat.

D'autres caractéristiques et avantages de l'invention apparaîtront à la lecture de la description détaillée qui suit et qui est faite en référence aux dessins annexés dans lesquels:

- la figure 1 déjà décrite est un exemple de schéma d'application dans lequel se pose un problème de protection de circuit-intégré;

- la figure 2 représente une coupe de structure classique de circuit-intégré;
- la figure 3 représente un schéma de circuit expliquant le principe de protection adopté selon l'invention;
- la figure 4 représente une coupe de structure de circuit-intégré mettant en oeuvre cette protection.

La figure 3 reprend les caractéristiques essentielles de l'invention dans l'application de joncteur d'abonné expliquée ci-dessus. La tension d'alimentation VBAT du standard est appliquée à une borne de sortie D du circuit intégré, mais cette borne n'est pas reliée directement au substrat. Au contraire elle est reliée au substrat par l'intermédiaire d'une diode D1 dont la cathode est reliée à la borne D et dont l'anode est reliée à un contact CS directement relié au substrat.

Dans tout ce qui suit , on considèrera que le substrat est de type p et la couche épitaxiale de type n; s'il n'en était pas ainsi, il faudrait inverser les dénominations anode et cathode.

Par ailleurs, la borne D n'amène pas directement la tension d'alimentation VBAT aux divers composants constituant le circuit de joncteur d'abonné; au contraire, la tension d'alimentation commune à tous ces composants est fournie par un conducteur interne au circuit intégré, conducteur représenté par un contact CA sur la figure 3, et ce conducteur est relié à la borne D par l'intermédiaire d'une diode D2 dont l'anode est connectée au conducteur interne CA et dont la cathode est reliée à la borne D.

Enfin, une diode D3 est prévue, son anode étant connectée au conducteur CA et sa cathode à la borne de sortie A du circuit-intégré (borne susceptible de recevoir une surtension); de même, une diode D'3 a son anode reliée au conducteur d'alimentation interne CA et sa cathode reliée à la borne de sortie B du circuit-intégré.

Cet ensemble de diodes se comporte comme un aiguillage pour appliquer au conducteur d'alimentation interne et au substrat la plus négative des trois tensions suivantes:

- tension d'alimentation externe VBAT (qui peut varier par exemple entre -34 volts et -72 volts)
- surtension éventuellement présente sur la borne A
- surtension éventuellement présente sur la borne B.

En l'absence de surtension, la tension d'alimentation VBAT est reportée, à la chute de tension près dans la diode D1, sur le substrat; elle est reportée aussi, à la chute de tension près dans la diode D2, sur le conducteur d'alimentation interne CA. Les diodes D1 et D2 sont alors polarisées en direct, mais il est bien prévu que l'anode de la diode D1, bien qu'elle soit connectée au substrat et qu'elle soit de type p comme le substrat, n'est pas constituée par une partie du substrat ni par une région de type p directement adjacente au substrat; au contraire, l'anode de la diode D1 est une région de type p placée dans un caisson de type n, et la cathode de la diode D1 est constituée non pas par ce caisson n mais par une région de type n intérieure à la région de type p constituant l'anode.

De cette manière, la polarisation directe de la diode D1 n'implique pas une polarisation directe indésirable entre le substrat et les divers caissons d'isolement du circuit-intégré.

En présence d'une surtension (supérieure en valeur absolue à VBAT) sur l'une des bornes de sortie ainsi protégées, par exemple la borne A, les diodes D1 et D2 se polarisent en inverse et les diodes D3 et D4 se polarisent en direct, appliquant ainsi la surtension au conducteur d'alimentation interne CA (à la chute de tension près dans la diode D3). Le conducteur CA devient ainsi le conducteur au potentiel le plus négatif du circuit. Le substrat prend en fait le même potentiel que ce conducteur CA, à travers une diode non représentée sur la figure 3, constituée par la jonction entre le caisson n sur lequel est pris le contact de sortie A et le substrat. Il y a alors polarisation directe indésirable d'une jonction entre un caisson et le substrat, mais seul un faible courant résiduel peut traverser cette jonction car le courant principal circule entre le conducteur CA et la borne A à travers la diode D3. Ce faible courant ne peut entrainer la mise en conduction de transistors parasites et encore moins la destruction du circuit. Quant à la diode D3, elle est isolée du substrat car on s'arrange d'une part pour que son anode ne soit pas adjacente à une portion de substrat et d'autre part pour que sa cathode ne soit pas adjacente à un caisson n adjacent au substrat; lorsque cette diode est parcourue par un courant important, elle ne déclenche pas la mise en conduction intempestive d'une jonction entre le substrat et un caisson adjacent au substrat.

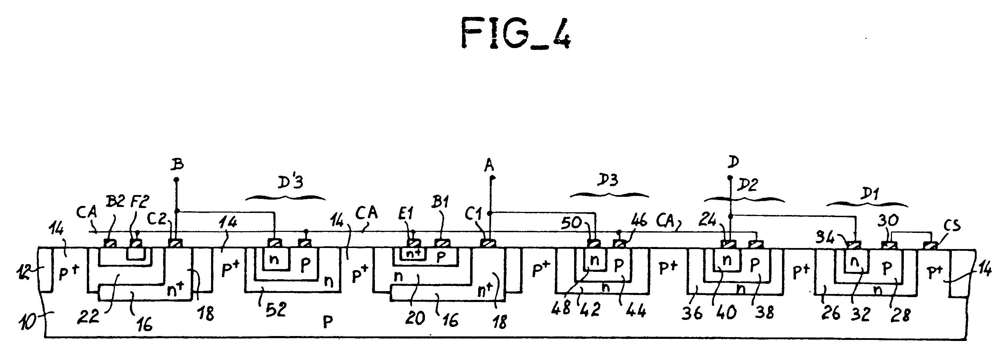

La figure 4 représente un exemple de structure de circuit-intégré mettant en oeuvre ce principe de protection, toujours dans l'application au joncteur d'abonné décrit ci-dessus. Les références utilisées sont les mêmes qu'aux figures précédentes pour les mêmes éléments.

La structure est réalisée sur un substrat 10 de type p recouvert d'une couche épitaxiale 12 de type n.

Des diffusions d'isolement 14 de type p+ s'étendent à partir de la surface supérieure de la couche épitaxiale et rejoignent le substrat. Des caissons de type n sont délimités par ces diffusions d'isolement et sont ainsi complètement isolés les uns des autres. Des couches enterrées 16 de type n+ peuvent être prévues comme à la figure 2 au fond de certains caissons, entre le caisson et le substrat. Des puits d'accès 18 à ces couches enterrées peuvent également être prévus.

On a représenté sur la figure 4 les bornes A et B de sortie du circuit-intégré sous forme de contacts C1 et C2 avec des régions de type n+ constituant des régions de collecteur pour des transistors de sortie du circuit. Ces transistors sont situés dans des caissons respectifs 20 et 22.

La borne d'alimentation externe D du circuit-intégré est représentée sous la forme d'un contact 24 sur la surface supérieure du circuit. Cette borne reçoit la tension VBAT.

On a ainsi redécrit sommairement les éléments de structure qui n'ont pas changé entre la figure 2 et la figure 4.

Les éléments spécifiques de l'invention sont les suivants.

Une diode D1 est formée dans un caisson 26 isolé des autres caissons.

Cette diode a son anode constituée par une région 28 de type p diffusée à l'intérieur du caisson 26. Cette région d'anode 20 est complètement isolée du substrat par le caisson 26 qui l'entoure. Une liaison électrique directe est réalisée entre cette anode et le substrat, par exemple au moyen d'un contact électrique 30 pris sur la surface de la région 28, d'un contact CS (cf.figure 3) pris sur la surface supérieure d'une diffusion d'isolement 14, et d'une liaison métallique entre ces deux contacts.

La cathode de la diode D1 est constituée par une diffusion 32 de type n formée à l'intérieur de la diffusion 28 de type p; un contact 34 est pris sur la surface supérieure de la région 32 et est relié par un conducteur métallique à la borne D.

Une diode D2 est formée dans un caisson 36. Son anode est constituée par une diffusion 38 de type p, isolée du substrat et des diffusions d'isolement par le caisson 36 qui l'entoure. Une liaison conductrice directe est réalisée entre cette région 38 et un conducteur d'alimentation interne CA qui fournit à l'ensemble du circuit la tension d'alimentation négative nécessaire au fonctionnement du circuit.

La cathode de la diode D2 est constituée par une région de type n 40, diffusée à l'intérieur de la région 38 de type p. Un contact (24 par exemple) avec cette région de cathode 40 permet de relier l'anode de la diode D2 à la borne D.

Une diode D3 est formée dans un caisson 42 isolé des autres caissons. L'anode de cette diode D3 est constituée par une région 44 de type p diffusée à l'intérieur du caisson 42. Un contact 46 permet de relier cette anode au conducteur d'alimentation interne CA.

La cathode de la diode D3 est réalisée par une diffusion 48 de type n formée à l'intérieur de la région 44 de type p et un contact 50 est pris sur la surface supérieure de la région de cathode 48, ce contact étant reliée par un conducteur à la borne A de sortie.

Enfin, puisque la borne B doit aussi être protégée dans cet exemple d'application, on a aussi prévu une diode D'3 constituée exactement comme la diode D3, dans un caisson 52, cette diode D'3 ayant son anode reliée au conducteur d'alimentation interne CA et sa cathode reliée à la borne de sortie B.

Cette réalisation n'a été donnée qu'à titre d'exemple et on pourrait concevoir des structures plus sophistiquées pour les diodes D1, D2, D3, D'3. Par exemple, la réalisation pourrait être la suivante: une couche enterrée de type n est prévue au fond d'un caisson; elle est surmontée, mais sur une partie de sa longueur seulement, par une couche enterrée de type p; un anneau de type p est diffusé par la surface supérieure jusqu'à la couche enterrée de type p; cet anneau entoure une région de type n qui constitue la cathode de la diode et sur laquelle un contact de cathode peut être pris; le contact d'anode peut être pris sur l'anneau de type p, cet anneau constituant l'anode.

**Revendications**

1. Circuit-intégré protégé contre les surtensions, réalisé sur un substrat semiconducteur (10) d'un premier type de conductivité recouvert d'une couche épitaxiale (12) du type opposé, le circuit comportant au moins une borne (D) d'alimentation extérieure, un conducteur (CA) d'alimentation interne pour transmettre une tension d'alimentation aux divers composants du circuit, et au moins une borne de sortie (A) susceptibles de recevoir des surtensions, ledit circuit-intégré comportant:

   - une première diode (D1) reliée entre le substrat et la borne d'alimentation extérieure (D), ayant sa cathode reliée à cette borne si le substrat est de type p;
   - une deuxième diode (D2) reliée entre le conducteur d'alimentation interne (CA) et la borne d'alimentation extérieure (D), ayant sa cathode reliée à cette borne si le substrat est de type p;
   - une troisième diode (D3) reliée entre le conducteur d'alimentation interne (CA) et la borne de sortie (A), ayant sa cathode reliée à cette borne si le substrat est de type p, cette troisième diode étant réalisée par une jonction entre deux régions (44, 48) de type de conductivité opposées, toutes deux électriquement isolées du substrat.

2. Circuit-intégré selon la revendication 1, caractérisé en ce que la troisième diode (D3) comporte une région d'anode (44) de type p formée à l'intérieur d'un caisson (42) de type n et une région de cathode de type n (48) formée à l'intérieur de la région d'anode.

3. Circuit-intégré selon l'une des revendications 1 et 2, caractérisé en ce que les première et deuxième diodes sont également réalisées par des jonctions entre des régions électriquement isolées du substrat.

## Claims

1. An overvoltage protected integrated circuit, carried out on a semiconductor substrate (10) of a first conductivity type, covered with an epitaxial layer (12) of the opposite conductivity type, the circuit comprising at least one external supply terminal (D), an internal supply terminal (CA) for transmitting a supply voltage to the various components of the circuit, and at least one output terminal (A) liable to receive overvoltages, said integrated circuit comprising :
    - a first diode (D1) connected between the substrate and the external supply voltage (D), its cathode being connected with said terminal if the substrate is p-type ;
    - a second diode (D2) connected between the internal supply conductor (CA) and the external supply terminal (D), its cathode being connected with said terminal if the substate is p-type ; and
    - a third diode (D3) connected between the internal supply conductor (CA) and the output terminal (A), having its cathode connected with said terminal if the substate is p-type, said third diode being implemented by means of a junction between two regions (44, 48) of opposite conductivity types, both being electrically insulated from the substrate.

2. An integrated circuit according to claim 1, characterized in this that the third diode (D3) comprises an p-type anode region (44) formed within the anode region.

3. An integrated circuit according to claim 1, characterized in this that said first and second diodes are also implemented by means of junctions between electrically insulated regions of the substrate.

## Patentansprüche

1. Gegen Überspannungen geschützter integrierter Schaltkreis, der auf einem Halbleitersubstrat (10) eines ersten Leitungstyps realisiert ist, das durch eine Epitaxialschicht (12) des entgegengesetzten Typs bedeckt ist, wobei der Schaltkreis mindestens einen Anschluß (D) zur externen Versorgung, einen Leiter (CA) zur internen Versorgung zum Übertragen einer Versorgungsspannung zu verschiedenen Bestandteilen des Schaltkreises und mindestens einen Ausgangsanschluß (A) enthält, der geeignet ist, Überspannungen aufzunehmen, wobei der besagte integrierte Schaltkreis enthält:
    - eine erste Diode (D1), die zwischen dem Substrat und dem Anschluß zur externen Versorgung (D) geschaltet ist, wobei ihre Kathode mit diesem Anschluß verbunden ist, wenn das Substrat vom P-Typ ist,
    - eine zweite Diode (D2), die zwischen dem Leiter zur internen Versorgung (CA) und dem Anschluß zur externen Versorgung (D) geschaltet ist, wobei ihre Kathode mit diesem Anschluß verbunden ist, wenn das Substrat vom P-Typ ist,
    - eine dritte Diode (D3), die zwischen dem Leiter zur internen Versorgung (CA) und dem Ausgangsanschluß (A) geschaltet ist, wobei ihre Kathode mit diesem Anschluß verbunden ist, wenn das Substrat vom P-Typ ist; diese dritte Diode wird durch einen Störstellenübergang zwischen zwei Bereichen (44, 48) mit entgegengesetztem Leitungstyp realisiert, die alle beide elektrisch von dem Substrat isoliert sind.

2. Integrierter Schaltkreis nach Anspruch 1, dadurch **gekennzeichnet,** daß die dritte Diode (D3) einen Anodenbereich (44) des P-Typs, der im Inneren eines Kastens (42) des N-Typs ausgebildet ist, und einen Kathodenbereich des N-Typs (48) enthält, der im Inneren des Anodenbereichs ausgebildet ist.

3. Integrierter Schaltkreis nach einem der Ansprüche 1 und 2, dadurch **gekennzeichnet,** daß die erste und die zweite Diode in gleicher Weise durch Stellenübergänge zwischen Bereichen gebildet werden, die elektrisch vom Substrat isoliert sind.

# FIG_1

# FIG_2

# FIG_3

# FIG_4

EP 0 289 431 B1